# FASCICULE DE BREVET EUROPEEN

(11) **EP 1 880 446 B1**
(45) Date de publication et mention de la délivrance du brevet: **02.01.2013**
(21) Numéro de dépôt: 06795297.8
(22) Date de dépôt: 11.05.2006
(51) Int. Cl.: H01R 12/57

(54) **METHODE DE CONNEXION SANS SOUDURE D'UN ACTIONNEUR ELECTRIQUE, NOTAMMENT POUR APPLICATION AUX TABLEAUX DE BORD AUTOMOBILE, A UN CIRCUIT IMPRIME**
VERFAHREN FÜR DIE LÖTFREIE VERBINDUNG EINES STELLGLIEDES MIT EINER GEDRUCKTEN SCHALTUNG, IM BESONDEREN GEEIGNET FÜR FAHRZEUGARMATURENBRETTER
METHOD FOR THE SOLDERLESS CONNECTION OF AN ELECTRIC ACTUATOR TO A PRINTED CIRCUIT, WHICH IS PARTICULARLY SUITABLE FOR MOTOR VEHICLE DASHBOARDS

(30) Priorité: 11.05.2005 FR 0551217
(43) Date de publication de la demande: 23.01.2008
(73) Titulaire: Sonceboz S.A., 2605 Sonceboz (CH)
(72) Inventeur: SIGG, Daniel, CH-2605 Sonceboz (CH); ZUPPIGER-LACHAT, Corinne, CH-2503 Bienne (CH)
(74) Mandataire: Breesé, Pierre
(86) Numéro de dépôt international: PCT/IB2006/002272
(87) Numéro de publication internationale: WO 2006/136957

(56) Documents cités:
- WO-A-2005/032224
- DE-A1- 19 735 409
- US-A- 3 670 409

## Description

La présente invention concerne une méthode de connexion sans soudure d'un actionneur électrique à un circuit imprimé, principalement pour des applications aux tableaux de bord automobile.

On connaît déjà dans l'art antérieur les méthodes classiques de soudure des composants électroniques sur les circuits imprimés, qu'ils soient traversants ou CMS -Composants Montés en Surface- (SMD en anglais). Par exemple, la méthode dite à *la vague* permet la soudure des composants traversants placés sur le circuit imprimé par une vague d'étain et de plomb qui vient au contact du circuit imprimé et ainsi souder les composants. Un autre exemple est la méthode dite de *refusion,* qui consiste à faire passer le circuit imprimé, sur lequel sont pré positionnés les composants avec un mélange d'étain et de plomb (crème à braser), dans des fours suivant différents paliers de température. Cette méthode est la plus répandue actuellement pour la soudure des composants CMS et a plusieurs avantages par rapport à la méthode *à la vague,* car elle permet une soudure plus efficace et elle est moins traumatisante pour l'ensemble des composants (évite les ponts et les zones d'ombre).

L'évolution des normes écologiques rend néanmoins ces techniques obsolètes et dangereuses pour l'environnement car elles nécessitent toujours l'utilisation de plomb, qui permet d'abaisser les températures de fusion des crèmes à braser à base d'étain (typiquement à 180°C). Des solutions sans plomb sont donc développées en accord avec les nouvelles directives, comme par exemple la directive RoHS (Restriction of Hazardous Substances), qui bannissent des crèmes à braser toutes substances nuisibles à l'environnement, notamment le plomb. Les nouvelles crèmes à braser utilisées, presque exclusivement constituées d'étain, ont donc le désavantage de nécessiter des températures de fusion plus hautes (autour des 220-230°C), qui peuvent détériorer les actionneurs électriques et/ou certains composants fragiles montés sur le circuit imprimé.

Il faut donc développer des solutions de connectique nouvelles.

Il existe déjà, dans l'art antérieur, des solutions permettant de résoudre ces problèmes grâce à l'insertion de connecteurs de type femelles, appelés connecteurs tulipe, qui sont soudés seuls au circuit imprimé avant la mise en place de l'actionneur et destinés à connecter et supporter l'actionneur. L'actionneur présente ainsi des pattes de connexion de type mâle qui permettent la connexion électrique de l'actionneur en complémentarité des connecteurs tulipe sans traumatisme de l'actionneur. Ces solutions ont le désavantage d'être coûteuses et de souvent comporter un élément en thermoplastique destiné à tenir les connecteurs tulipe. De plus, si la connexion électrique est assurée, la tenue mécanique n'est pas parfaite, ce qui peut être préjudiciable pour des applications comme les micromoteurs utilisés sur les tableaux de bord automobile. En effet, l'ensemble circuit imprimé + actionneur est soumis à des vibrations qui peuvent être importantes et il y a une réelle nécessité d'une bonne tenue mécanique. Pour cela, il faut traditionnellement rajouter une pièce servant à tenir mécaniquement l'actionneur sur le circuit, par exemple une bride. Ceci augmente les coûts de production et ajoute une étape supplémentaire dans le montage de l'actionneur.

Il existe aussi un mode de connexion dit *ajustable à force* (*press-fit* en anglais) qui ne nécessite pas de soudure et permet la connexion électrique par la déformation mécanique d'un connecteur dans un perçage du circuit imprimé. L'actionneur peut ainsi être connecté sans soudure au connecteur. Cette solution est pratique car évite d'avoir à souder les composants, mais elle connaît aussi des désavantages : la force d'insertion sur le circuit imprimé est importante, ce qui peut détériorer ledit circuit, et les tolérances de réalisation des connecteurs et des perçages sur circuit imprimé doivent être précises afin d'assurer un maintien mécanique suffisant.

L'état de la technique comprend en particulier la demande de brevet internationale WO2005/032224 dans lequel la fiche métallique à fixer présente un diamètre supérieur à du trou récepteur prévu dans le circuit imprimé. De ce fait, l'insertion se fait par chassage mécanique dans le circuit imprimé. L'effort de connection est élevé et crée des contraintes préjudiciable sur le circuit imprimé. Cette solution prévoit par ailleurs une soudure après mise en place de l'élément à raccorder.

Le brevet US3670409 présente une autre solution dans laquelle des feuilles conductrices sont fixées sur un circuit imprimé au moyen d'un adhésif.

Le brevet DE 19735409 présente une méthode de connexion selon le préambule de la revendication 1.

La présente invention apporte une solution à ces problèmes et propose, à cet effet, une méthode de connexion industrielle de l'actionneur au circuit imprimé selon la revendication 1, en grand volume, économique, automatisée et à grande cadence, ne nécessitant pas de soudure au niveau de l'actionneur et assurant une bonne tenue mécanique de l'actionneur sur le circuit imprimé. Dans un premier temps, la méthode consiste en un report de type CMS d'un contact métallique spécifique, simple et économique, spécialement développé pour la mise en oeuvre de l'invention. Ces contacts métalliques présentent une zone ouverte de contact qui peut être réalisé par étampage, cisaillement ou tout moyen équivalent. Différents moyens de livraison sont envisageables selon l'état de l'art actuel on citera par exemple les méthodes suivantes : unitairement en vrac, en bandes adaptés aux machines de placement, en « tape&reel » où chacun des contacts sont individuellement placés dans un support plastique... Ces contacts sont, de manière préférentiel mais non limitative, faits d'acier et ont une épaisseur typiquement voisine de 0.1 mm. Ils présentent généralement un revêtement (coating en anglais) permettant leur soudure plus facile sur le circuit imprimé. Le mélange permettant la soudure du contact est préalablement déposé à l'endroit du contact sur le circuit. Une fois les contacts déposés, le circuit est placé dans un four suivant un profil de température variable défini. Les contacts électriques et les autres composants sont donc soudés pendant cette opération.

Dans un deuxième temps, une fois le circuit imprimé soudé avec l'ensemble des composants CMS (contacts métalliques, LED, électronique de pilotage, ...), l'actionneur peut être connecté, sans soudure et sans traumatisme de température, sur le circuit et sans nécessiter une force d'insertion importante. La connexion est réalisée par l'insertion des pattes de connexion électrique, liées à l'actionneur, dans les contacts métalliques spécialement placés sur le circuit imprimé et qui présentent une ouverture, préférentiellement en forme de croix, que les pattes de connexion de l'actionneur viennent traverser.

Cette forme, qui n'est pas limitative, peut être réalisé par étampage, c'est-à-dire en enlevant de la matière, ou par cisaillement, où l'on découpe sans perte de matière. Il est ainsi possible de choisir la méthode de réalisation selon les impératifs de production éventuels. Il peut être envisagé une autre forme : circulaire ou plus généralement une forme d'étoile à plusieurs branches.

Cette forme particulière permet de griffer les pattes de connexion et d'assurer le contact électrique. Des striures présentes sur les pattes de connexion permettent, de plus, le maintien rigide de la connexion. Ces striures ne sont toutefois pas indispensables puisque la connexion des pattes est assurée par le contact physique entre les deux éléments.

Ces pattes de connexion sont semblables aux pattes de connexion électrique habituellement utilisées sur les actionneurs et soudées comme n'importe quel composant traversant. C'est en effet un des objectifs de la présente invention de proposer un actionneur avec des pattes de connexion électrique qui peuvent être au choix soudées par les méthodes traditionnelles de soudure des éléments traversants, ou par la présente méthode proposée, sans nécessiter deux types de pattes différentes.

Dans un mode de réalisation préférentielle, le circuit imprimé présente des pads, c'est-à-dire des emplacements étamés, qui ont une forme sensiblement carrée. Ils sont destinés à recevoir les contacts métalliques de forme sensiblement carrés qui ont une longueur de coté comprise préférentiellement entre 0.8 fois et 1 fois la longueur du coté dudit pad. Cette forme et relation géométrique permettent d'assurer un auto centrage du contact métallique sur le pad lors de l'étape de soudage. Il en résulte que le positionnement des contacts métalliques est tout à fait précis et assure une orientation optimale de l'ouverture par rapport à la patte de connexion.

Il est bien sûr possible d'envisager une forme de pad rond.

Dans un mode de réalisation préférentiel, le contact métallique présente une ouverture en forme de croix et la patte de connexion présente une forme carrée. Le placement du moteur sur le circuit imprimé assure donc une connexion électrique sûre sans indexation nécessaire, et un auto centrage de la patte de connexion dans le contact métallique.

Dans un mode de réalisation préférentiel, le circuit imprimé présente des ouvertures de type cylindrique traversantes permettant de laisser passer les pattes de connexion et permettant à la forme de croix du contact métallique de se déformer librement lors de la connexion de la patte de connexion sur le contact métallique.

Un autre des objets de l'invention est de proposer une méthode qui peut être utilisée pour un montage avant du moteur, c'est-à-dire avec le moteur placé sur la face supérieure du circuit imprimé du coté des composants électriques, ou bien en montage arrière, c'est-à-dire le moteur placé sur le coté inférieur du circuit imprimé à l'opposé des composants.

Ainsi, il est possible d'envisager de pré-plier le contact métallique au niveau de l'ouverture d'un coté ou de l'autre du circuit imprimé afin de faciliter l'insertion des pattes de connexion. Il est aussi possible de ne pas pré-plier la zone d'ouverture du contact afin de réaliser un ensemble circuit imprimé + contacts métalliques unique utilisable pour les deux versions de montages existants.

Dans le cas où l'on est en configuration de montage arrière la déformation de la zone ouverte se fait à l'opposé du perçage du circuit imprimé. Dans ce cas-là on peut envisager de réaliser un perçage d'un diamètre plus petit afin d'assurer une surface de soudage optimale du contact métallique sur le circuit imprimé.

Dans le cas où l'on est en montage avant le diamètre du perçage du circuit imprimé doit être au minimum supérieur au diamètre dans lequel la pliure de la zone ouverte se fait.

La compréhension de cette description sera facilitée en se référant aux dessins ci-joints dans lesquels :
- La figure 1A représente une vue d'un connecteur électrique de type tulipe de l'art antérieur.
- La figure 1B représente une vue d'un connecteur thermoplastique sur lequel sont disposés plusieurs connecteurs électriques de type tulipe de l'art antérieur.
- La figure 2 représente un type de connexion dit *ajustable à force (Press-fit)* de l'art antérieur.
- La figure 3 présente deux contacts métalliques, dans un premier mode de réalisation, utilisés dans la présente méthode.
- La figure 4 montre un ensemble de contacts métalliques, dans un second mode de réalisation, présentés en une bande.
- La figure 5 montre un ensemble de contacts métalliques, dans un second mode de réalisation, présentés en plusieurs bandes.
- La figure 6 montre un contact métallique décrit par la présente invention dans un premier mode de réalisation de l'ouverture par étampage.
- La figure 7 montre un contact métallique décrit par la présente invention dans un second mode de réalisation de l'ouverture par cisaillement.
- La figure 8 montre une vue d'un pad ou surface étamée réalisé sur un circuit imprimé pour lequel se destine le contact métallique de la présente méthode.
- La figure 9 présente un contact métallique placé sur le pad du circuit imprimé avant insertion d'une patte de connexion.
- La figure 10 représente une vue agrandie d'un contact métallique utilisé dans la présente méthode.
- La figure 11 représente une vue des contacts métalliques utilisés dans la présente méthode soudés sur un circuit imprimé.
- La figure 12 montre une coupe d'un circuit imprimé sur lequel est placé un contact métallique utilisé par la présente invention, avec la zone ouverte déformée du coté du circuit imprimé.
- La figure 13 montre une coupe d'un circuit imprimé sur lequel est placé un contact métallique utilisé par la présente invention, avec la zone ouverte non déformée.
- La figure 14 montre une coupe d'un circuit imprimé sur lequel est placé un contact métallique utilisé par la présente invention, avec la zone ouverte déformée à l'opposée du circuit imprimé.
- La figure 15 montre une coupe d'un circuit imprimé sur lequel est placé un contact dans lequel est connecté une patte de connexion électrique d'un actionneur en montage arrière.
- La figure 16 représente un actionneur électrique prêt à être connecté sur un circuit imprimé grâce à la présente méthode.
- La figure 17 montre une coupe d'un circuit imprimé sur lequel est placé un contact métallique utilisé par la présente invention et un actionneur de tableau de bord connecté au contact métallique.
- La figure 18 représente une vue isolée d'une patte de connexion électrique d'un actionneur à connecter suivant la présente invention.
- La figure 19 montre un contact métallique dans lequel est connecté une patte de connexion d'un actionneur, dans un autre mode de réalisation qui est donné a titre d'example et ne fait pas parti de l'invention.

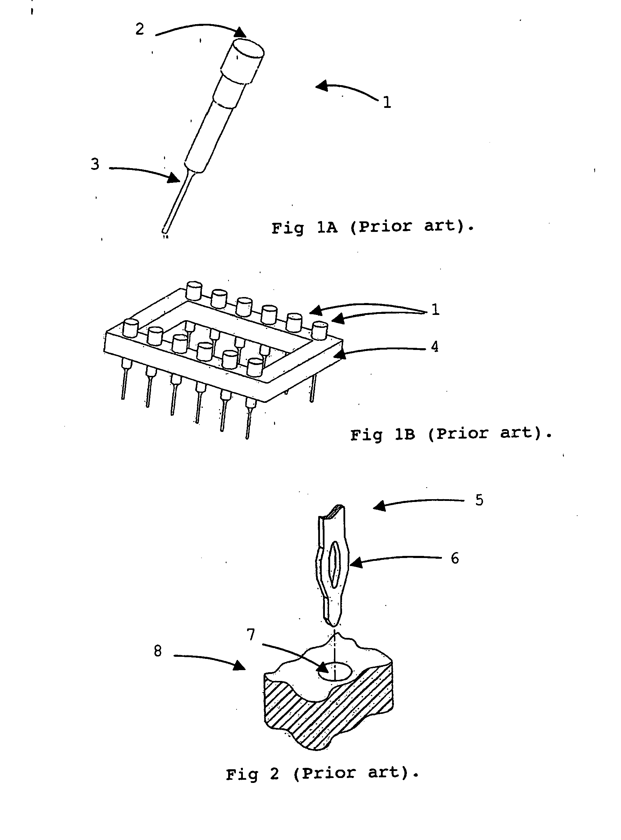

La figure 1A montre un connecteur tulipe (1), largement utilisé depuis des années dans le domaine des connexions électroniques. Cet élément est destiné à recevoir sur sa partie supérieure (2) une patte de connexion électrique, par exemple appartenant à un actionneur électrique. L'extrémité inférieure (3) de ce connecteur tulipe (1) est réalisée de façon à passer à travers un perçage réalisé sur un circuit imprimé (non visible), et destinée ensuite à être soudée au dit circuit imprimé. Ce type de connecteur, s'il permet un bon contact électrique à l'intérieur du connecteur tulipe (1), ne permet cependant pas de garantir une tenue mécanique suffisante pour des applications sensibles où les vibrations sont nombreuses et d'amplitudes importantes, comme par exemple les actionneurs destinés aux tableaux de bord automobile.

Ce connecteur tulipe (1) peut aussi être intégré à un support regroupant plusieurs connecteurs du même type, ce qui permet de placer en une seule opération tous les connecteurs tulipes d'une application. Un exemple d'un tel support est montré en figure 1B où l'on retrouve douze connecteurs tulipes (1) placés dans un support (4). Ce support (4) est destiné ensuite à être posé sur un circuit imprimé (non visible) où l'on viendra ensuite souder chaque connecteur tulipe (1). Ce type de support est connu depuis des années, mais représente une pièce supplémentaire, généralement thermoplastique, qui impose un surcoût et nécessite une installation sur le circuit imprimé.

La figure 2 montre un connecteur (5) dit ajustable à force (Press-fit) de l'art antérieur. Ce connecteur (5) est constitué d'une partie centrale déformable (6), formée généralement d'un perçage et de deux parties externes écartées. Lors de l'insertion du connecteur (5) dans le perçage (7) du support (8), qui peut être un circuit imprimé, la partie centrale déformable (6) se déforme par la pression exercée sur le support (8) et va alors créer une connexion électrique et un maintien mécanique du connecteur (5) par réaction et frottement de d'intérieur du perçage (7) sur la partie centrale déformable (6). Les inconvénients de ce type de connexion sont la grande force nécessaire à l'insertion du connecteur (5) dans le support (8), pouvant détériorer ledit support (8), et la précision des tolérances mécaniques indispensables à la qualité de la connexion.

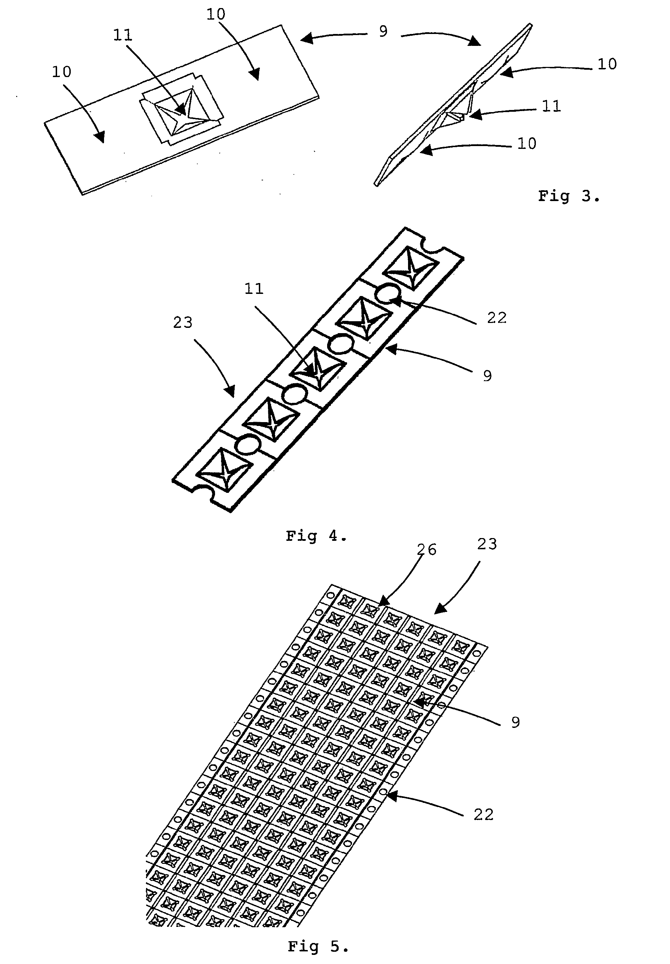

La figure 3 montre deux contacts métalliques (9) utilisés dans la nouvelle méthode que présente cette demande. Ils sont, de manière préférentielle, réalisés en acier et ont une épaisseur voisine de 0.1mm, valeur qui n'est pas limitative. Ce contact métallique (9), destiné à être soudé sur un circuit imprimé, présente, par exemple, deux zones de fixation (10) au circuit imprimé bombées qui vont former les zones de soudure au circuit imprimé. Cette forme particulière est un exemple de ce qui est possible mais n'est pas limitative. Le contact métallique (9) présente une deuxième zone qui est une zone de contact électrique (11) entre le circuit imprimé et l'organe à alimenter, par exemple un actionneur électrique. Cette zone de contact électrique (11) est ici représentée en forme de croix. La zone de contact électrique (11) doit être ouverte ou permettre son ouverture lors du passage d'un élément de connexion électrique extérieur.

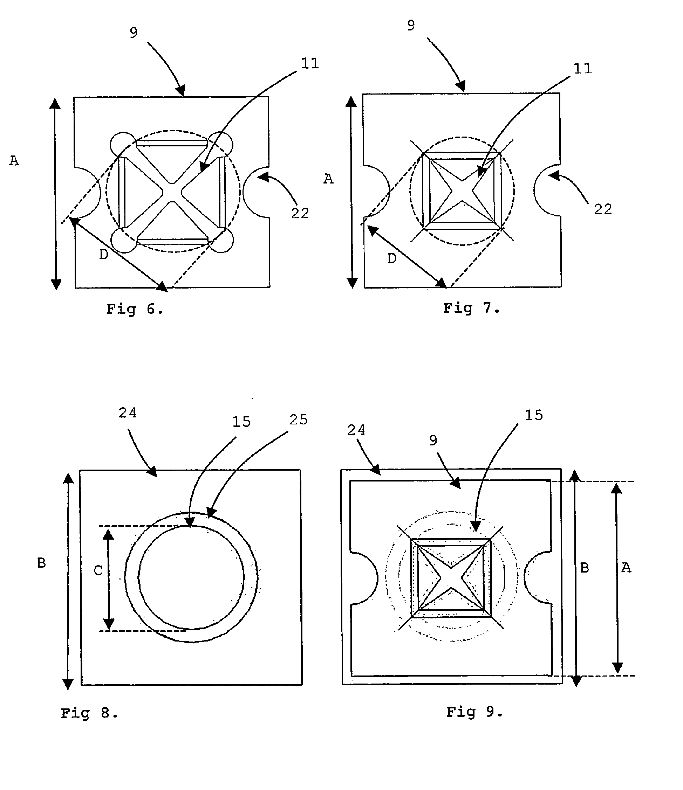

La figure 4 présente les contacts métalliques (9) en bande (23) dans un premier mode de réalisation et avant utilisation. Ils comprennent de façon avantageuse mais nullement limitative une zone de découpe (22) servant à manipuler et faire avancer la bande (23) par l'outil de découpage. La zone de contact électrique (11) est visible. Elle peut être réalisée par étampage comme montré en figure 6, c'est-à-dire où l'on vient enlever la matière pour former la zone de contact (11). Elle peut aussi être réalisée par cisaillement, comme montré en figure 7, c'est-à-dire en découpant la matière sans perte. On choisira l'une ou l'autre des méthodes suivant les impératifs de production.

La figure 5 présente les contacts métalliques (9) en bande (23) dans un second mode de réalisation et avant utilisation. Dans ce mode de réalisation où plusieurs rangées (26) sont positionnées les unes à coté des autres, il peut être envisagé de créer des zones de découpe (22) servant à manipuler et faire avancer la bande (23) par l'outil de découpage.

Dans un mode de réalisation préférentielle, la forme du contact métallique (9) est sensiblement carrée dont la longueur du coté est noté A.

Dans les deux cas, la zone d'ouverture définit un diamètre D à l'intérieur duquel la pliure de la zone de contact est possible.

Ce contact métallique (9) est destiné à venir se placer sur un pad ou zone étamée (24) du circuit imprimé (13), comme montré en figure 8, qui présente avantageusement une forme sensiblement carrée dont la longueur du coté est notée B. Lors du soudage du contact métallique par une méthode type CMS (par exemple par refusion) et afin d'assurer un auto centrage du contact métallique (9) sur le pad (24), comme montré en figure 9, la longueur du coté A doit être avantageusement comprise entre 0.8 et 1 fois la longueur du coté B.

La forme carrée étamée du pad (24) est généralement délimitée par un diamètre (25) à l'intérieur duquel il n'y plus d'étamage. Le perçage (15) traversant réalisé sur le circuit imprimé (13) et servant à laisser passer une patte de connexion électrique (17) est réalisé sur un diamètre C inférieur au diamètre intérieur d'étamage (25).

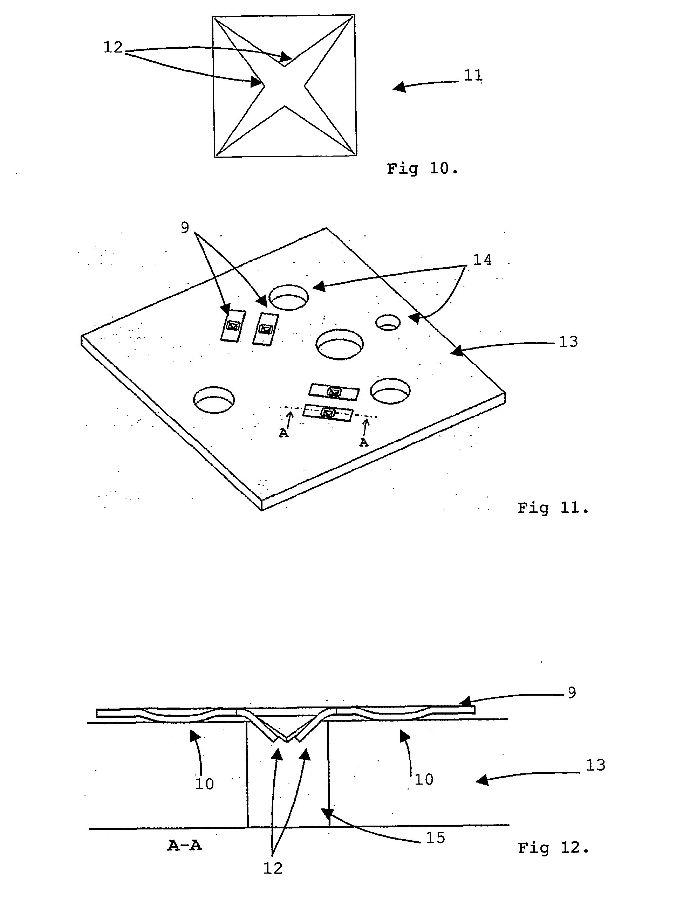

La figure 10 montre un agrandissement de la zone de contact électrique (11) en forme de croix. Au passage des pattes de connexion électrique (17), le contact électrique est crée, défini ici par quatre points de contact (12) en forme de pointe ; ni le nombre ni la forme des points de contact (12) n'étant limitatifs. De manière préférentielle, la découpe au niveau de la zone de contact électrique (11) est réalisée de manière à ce que les points de contact (12) soient courbés côté circuit imprimé (13), de façon à faciliter l'insertion des pattes de connexion électrique (17).

Avant cette insertion, les contacts métalliques (9) une fois réalisés sont ensuite pré positionnés sur un circuit imprimé (13) comme indiqué en figure 11. La position relative de chaque contact métallique (9) est fonction des caractéristiques géométriques de l'actionneur à connecter. Dans cet exemple l'actionneur à connecter contient deux bobines d'alimentation électrique indépendantes, ce qui correspond donc à quatre connexions distinctes. Le circuit imprimé (13) présente aussi des perçages (14) de différentes dimensions, destinés à positionner l'actionneur électrique relativement aux contacts métalliques (9) et ainsi faciliter la connexion.

La figure 12, qui est une vue en coupe du circuit imprimé (13) suivant la ligne de dessin A-A de la figure 11, précise le positionnement du contact métallique (9) sur ledit circuit imprimé (13). On retrouve les zones de fixations (10) en contact avec le circuit imprimé (13) à l'endroit où la soudure est effectué à l'aide, par exemple, d'une méthode de *refusion.* Pour cela, une crème à braser doit être préalablement placée à l'endroit de contact des zones de fixation (10) sur le circuit imprimé (13). Ces deux zones de fixation (10) assurent la tenue des contacts métalliques (9) sur le circuit imprimé (13) et permettent le positionnement de la zone de contact électrique (11) à l'intérieur d'un perçage (15) réalisé préalablement dans le circuit imprimé (13). Les quatre points de contact (12) pourront alors librement et aisément se déformer lors de la connexion de l'actionneur.

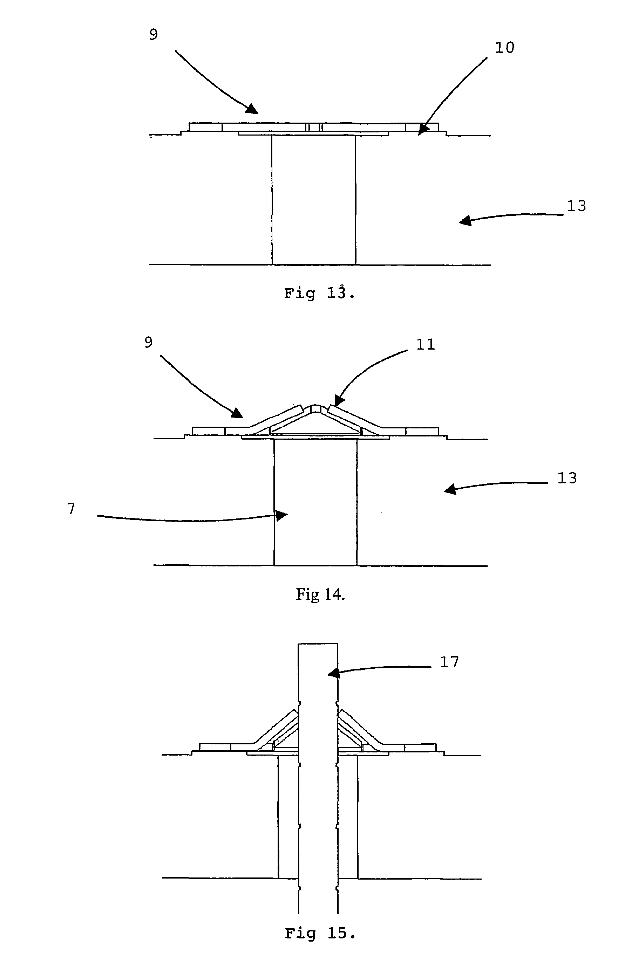

Sur la figure 13, le contact métallique (9) est pré positionné sur le circuit imprimé (13) comme sur la figure (12). Ce contact métallique (9), suivant un second mode de réalisation, présente une forme carrée et ne présente pas de zones de fixation spécifique. C'est toute la surface du contact (9) qui représente cette zone de fixation (10). Dans cette configuration, la zone de contact électrique (11) n'est pas préformée afin de pouvoir recevoir une patte de connexion (17) d'un actionneur (16), en montage arrière ou avant. Il n'y a ainsi qu'un seul ensemble circuit imprimé + contacts utilisable pour les deux types de montage possibles.

Sur la figure 14, le contact (9) présente une zone de contact électrique (11) déformée à l'opposé du circuit imprimé afin de recevoir une patte de connexion électrique (17) d'un actionneur (16) monté en montage arrière. Dans cette configuration, il est possible de réaliser un perçage (7) d'un diamètre plus petit afin d'optimiser la surface de soudage du contact métallique (9) sur le circuit imprimé (13). La figure 15 montre la patte de connexion (17) d'un actionneur (16) placé en montage arrière. La zone de contact électrique (11) s'est déformée lors de l'insertion de la patte (17) est la connexion électrique est assurée par contact.

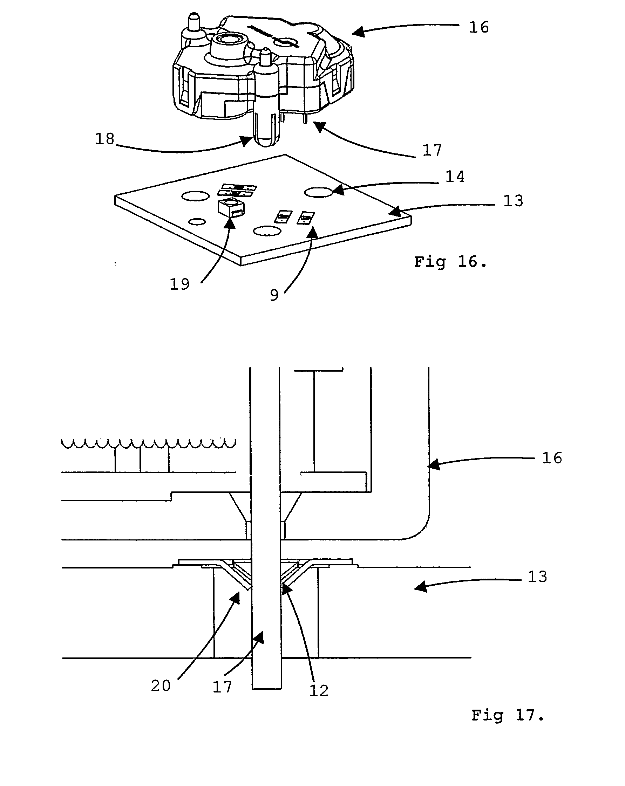

Sur la figure 16, un actionneur (16) est montré approchant du circuit imprimé (13). Cet actionneur (16) peut par exemple être tel que décrit dans la demande de brevet française FR2859323. Il comporte ainsi 4 pattes de connexion électrique (17), dont deux sont visibles, destinées à être placées à travers la zone de contact électrique (11) du contact métallique (9). L'actionneur (16) présente, de plus, des pattes de positionnement mécanique (18) qui sont destinés à assurer le positionnement et la fixation de l'actionneur (16) sur le circuit imprimé (13) par complémentarité avec les perçages (14) réalisés. Une LED (19) servant à éclairer un pointeur (non visible) piloté par l'actionneur (16), est aussi positionné sur le circuit imprimé (13).

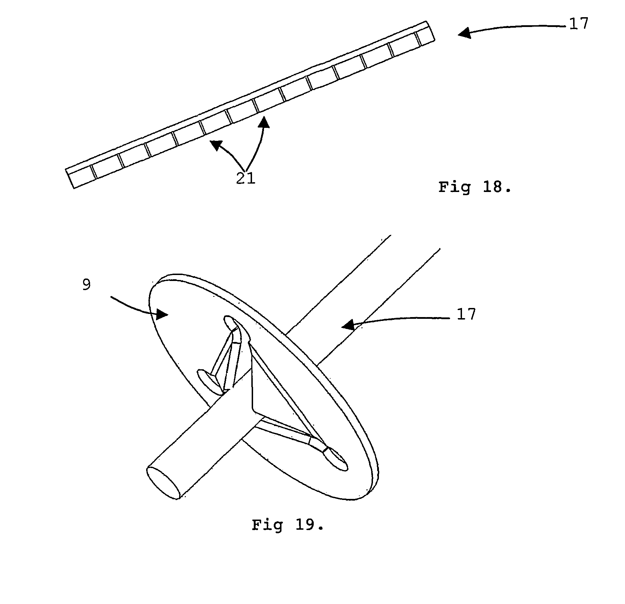

Une fois inséré à travers les zones de contact électrique (11), l'actionneur (16) est positionné fixe sur le circuit imprimé (13). La figure 17 montre une vue en coupe de l'actionneur (16) sur le circuit imprimé (13). On y voit la zone de contact (20) entre une des pattes de connexion électrique (17) et les points de contact (12) en forme de pointe du contact métallique (9). Cette connexion crée non seulement un contact électrique fiable entre l'actionneur (16) et le circuit imprimé (13), mais elle permet aussi une bonne tenue mécanique, par la griffure des points de contact (12) sur les pattes de connexion électrique (17) dont on voit une vue isolée en figure 18, et l'arc-boutement des points de contact (12) après insertion des pattes de connexion électrique (17) appartenant à l'actionneur (16). Les pattes de connexion électrique (17) présentent, en effet, et de manière préférentiel mais non limitative, des striures (21) perpendiculaires à l'axe de la patte de connexion électrique (17). De manière préférentielle, le maintien mécanique est garanti par la réalisation des points de contacts (12), courbés du côté du circuit imprimé (13), ce qui limite la réversibilité du mouvement. Le maintien mécanique obtenu est fiable et apte à immobiliser l'ensemble lors de vibrations éventuelles pendant le fonctionnement de l'actionneur (16) dans l'application. Les pattes de connexion électrique (17) sont semblables aux pattes de connexion traditionnellement utilisées pour les actionneurs de tableaux de bord et peuvent, à ce titre, être aussi bien soudées au circuit imprimé (13) par une quelconque méthode de soudure des composants traversants décrite par l'état de l'art actuel.

La figure 19 montre une vue isolée d'un contact métallique (9) avec une patte de connexion électrique (17) d'un actionneur (16) dans un autre mode de réalisation. Le contact métallique (9) et la patte de connexion (17) sont sensiblement de forme circulaire et sont destinés à venir se placer sur un pad (24) lui aussi de forme sensiblement circulaire.

## Revendications

1. Méthode de connexion d'un actionneur électrique à un circuit imprimé par l'intermédiaire de contacts métalliques (9) présentant une zone de contact ouverte où les contacts métalliques (9) sont soudés au circuit imprimé (13) par une méthode automatisée de type CMS à grande cadence à haute température et où les pattes de connexion électrique de l'actionneur peuvent être connectés mécaniquement sans soudure sur les contacts métalliques par arc-boutement de la zone de contact (11) des contacts métalliques (9) sur les pattes de connexion de l'actionneur après insertion desdites pattes de connexion au travers de ladite zone de contact, la zone de contact (11) ouverte présentant une forme de croix et **caractérisée en ce que** la patte (17) de connexion présentant une forme carré.

2. Méthode de connexion d'un actionneur électrique à un circuit imprimé selon la revendication 1 **caractérisée en ce que** le circuit imprimé (13) présente des pads (24) étamés de connexion sensiblement carrés et **en ce que** les contacts métalliques (9) présentent une forme sensiblement carrée, destinés à venir se placer sur lesdits pads, et ayant une longueur de coté comprise entre 0.8 fois et 1 fois la longueur du coté dudit pad.

3. Méthode de connexion d'un actionneur électrique à un circuit imprimé par l'intermédiaire de contacts métalliques suivant la revendication 1 ou 2 **caractérisée en ce que** le circuit imprimé présente des perçages (15) traversants aptes à laisser passer les pattes de connexion électrique de l'actionneur.

4. Méthode de connexion d'un actionneur électrique à un circuit imprimé par l'intermédiaire de contacts métalliques (9) suivant les revendications précédentes **caractérisée en ce que** les pattes de connexion électrique (17) de l'actionneur sont aussi soudables sur un circuit imprimé par les moyens de soudure utilisés dans l'état de l'art actuel pour les composants traversants.

5. Méthode de connexion d'un actionneur électrique à un circuit imprimé par l'intermédiaire de contacts métalliques (9) suivant les revendications précédentes **caractérisée en ce que** la zone de contact (11) est réalisée courbée côté circuit imprimé.

6. Méthode de connexion d'un actionneur électrique à un circuit imprimé par l'intermédiaire de contacts métalliques (9) suivant les revendications précédentes **caractérisée en ce que** la zone de contact (11) est réalisée courbée à l'opposé du circuit imprimé.

7. Méthode de connexion d'un actionneur électrique à un circuit imprimé par l'intermédiaire de contacts métalliques (9) suivant les revendications précédentes **caractérisée en ce que** les pattes de connexion électrique (17) de l'actionneur présentent des striures (21) perpendiculaires à l'axe desdites pattes de connexion électrique.

8. Méthode de connexion d'un actionneur électrique à un circuit imprimé par l'intermédiaire de contacts métalliques suivant les revendications précédentes **caractérisée en ce que** les contacts métalliques (9) présentent des surfaces planes de contact au circuit imprimé (13).

9. Méthode de connexion d'un actionneur électrique à un circuit imprimé (13) par l'intermédiaire de contacts métalliques (9) suivant les revendications précédentes **caractérisée en ce que** les contacts métalliques présentent des surfaces de contact (11) au circuit imprimé bombées.

10. Méthode de connexion d'un actionneur électrique à un circuit imprimé (13) par l'intermédiaire de contacts métalliques suivant les revendications précédentes **caractérisée en ce que** le circuit imprimé présente des perçages (14) aptes à laisser passer des éléments de guidage mécanique et de fixation appartenant à l'actionneur.

11. Méthode de connexion d'un actionneur électrique à un circuit imprimé par l'intermédiaire de contacts métalliques (9) suivant les revendications précédentes **caractérisée en ce que** les contacts métalliques sont réalisés en acier.

12. Méthode de connexion d'un actionneur électrique à un circuit imprimé par l'intermédiaire de contacts métalliques (9) suivant les revendications précédentes **caractérisée en ce que** les contacts métalliques présentent une zone de contact (11) en forme d'étoile à plusieurs branches.

## Claims

1. A method of connecting an electrical actuator to a printed circuit by means of metal contacts (9) having an open contact area where the metal contacts (9) are welded to the printed circuit (13) by an automated method of the high-rate high-temperature CMS type and where the electrical connection lugs of the actuator can be connected mechanically without welding to the metal contacts by buttressing of the contact area (11) of the metal contacts (9) on the connection lugs of the actuator after insertion of said connection lugs through said contact area, the open contact area (11) being cruciform and **characterised in that** the connection lug (17) has a square shape.

2. A method of connecting an electrical actuator to a printed circuit according to claim 1, **characterised in that** the printed circuit (13) has substantially square tinned connection pads (24) and **in that** the metal contacts (9) have a substantially square shape, intended to be placed on said pads, and having a side length of between 0.8 times the length of and the same length as the side of said pad.

3. A method of connecting an electrical actuator to a printed circuit by means of metal contacts according to claim 1 or 2, **characterised in that** the printed circuit has through piercings (15) for allowing the electrical connection lugs of the actuator to pass.

4. A method of connecting an electrical actuator to a printed circuit by means of metal contacts (9) according to the preceding claims, **characterised in that** the electrical connection lugs (17) of the actuator are also weldable to a printed circuit by the welding means used in the current prior art for the through components.

5. A method of connecting an electrical actuator to a printed circuit by means of metal contacts (9) according to the preceding claims, **characterised in that** the contact area (11) is produced so as to be curved on the printed circuit side.

6. A method of connecting an electrical actuator to a printed circuit by means of metal contacts (9) according to the preceding claims, **characterised in that** the contact area (11) is produced so as to be curved on the opposite side to the printed circuit.

7. A method of connecting an electrical actuator to a printed circuit by means of metal contacts (9) according to the preceding claims, **characterised in that** the electrical connection lugs (17) of the actuator have serrations (21) perpendicular to the axis of said electrical connection lugs.

8. A method of connecting an electrical actuator to a printed circuit by means of metal contacts according to the preceding claims, **characterised in that** the metal contacts (9) have flat surfaces for contact on the printed circuit (13).

9. A method of connecting an electrical actuator to a printed circuit (13) by means of metal contacts (9) according to the preceding claims, **characterised in that** the metal contacts have surfaces (11) for contact on the printed circuit that are curved.

10. A method of connecting an electrical actuator to a printed circuit (13) by means of metal contacts according to the preceding claims, **characterised in that** the printed circuit has piercings (14) for mechanical guidance and fixing elements belonging to the actuator to pass.

11. A method of connecting an electrical actuator to a printed circuit by means of metal contacts (9) according to the preceding claims, **characterised in that** the metal contacts are produced from steel.

12. A method of connecting an electrical actuator to a printed circuit by means of metal contacts (9) according to the preceding claims, **characterised in that** the metal contacts have a contact area (11) in the form of a star with several arms.

## Patentansprüche

1. Verfahren zum Anschluss eines elektrischen Wirkgliedes an eine Leiterplatte mittels metallischer Kontakte (9), die eine offene Kontaktzone aufweisen, in der die metallischen Kontakte (9) durch ein automatisiertes Verfahren vom Typ CMS unter hohem Arbeitstakt bei hoher Temperatur an die Leiterplatte (13) geschweißt sind und in der die Klauen des elektrischen Anschlusses des Wirkgliedes mechanisch ohne Schweißnaht auf den metallischen Kontakten durch Hängen der Kontaktzone (11) der metallischen Kontakte (9) auf den Anschlussklauen des Wirkgliedes nach dem Einführen der genannten Anschlussklauen über die genannte Kontaktzone angeschlossen werden, wobei die offene Kontaktzone (11) eine Kreuzform aufweist, **dadurch gekennzeichnet, dass** die Anschlussklaue (17) eine Quadratform aufweist.

2. Verfahren zum Anschluss eines elektrischen Wirkgliedes an eine Leiterplatte gemäß Anspruch 1, **dadurch gekennzeichnet, dass** die Leiterplatte (13) angerissene Pads (24) zum Anschluss aufweist, die deutlich quadratisch sind und dass die metallischen Kontakte (9) eine deutlich quadratische Form aufweisen und dazu bestimmt sind, auf den genannten Pads platziert zu werden und eine zwischen 0,8 Mal und 1 Mal der Länge der Seite des genannten Pads inbegriffene Seitenlänge haben.

3. Verfahren zum Anschluss eines elektrischen Wirkgliedes an eine Leiterplatte mittels metallischer Kontakte gemäß Anspruch 1 oder 2, **dadurch gekennzeichnet, dass** die Leiterplatte durchquerende Bohrungen (15) aufweist, die geeignet sind, die Klauen des elektrischen Anschlusses des Wirkgliedes durchtreten zu lassen.

4. Verfahren zum Anschluss eines elektrischen Wirkgliedes an eine Leiterplatte mittels metallischer Kontakte (9) gemäß den voranstehenden Anschlüssen, **dadurch gekennzeichnet, dass** die Klauen (17) des elektrischen Anschlusses des Wirkgliedes ebenfalls auf einer Leiterplatte mittels der Schweißmittel schweißbar sind, die im aktuellen Stand der Technik für die durchquerenden Bauteile verwendet werden.

5. Verfahren zum Anschluss eines elektrischen Wirkgliedes an eine Leiterplatte mittels metallischer Kontakte (9) gemäß den voranstehenden Ansprüchen, **dadurch gekennzeichnet, dass** die Kontaktzone (11) auf der Seite der Leiterplatte gekrümmt realisiert ist.

6. Verfahren zum Anschluss eines elektrischen Wirkgliedes an eine Leiterplatte mittels metallischer Kontakte (9) gemäß den voranstehenden Ansprüchen, **dadurch gekennzeichnet, dass** die Kontaktzone (11) gegenüber der Leiterplatte gekrümmt realisiert ist.

7. Verfahren zum Anschluss eines elektrischen Wirkgliedes an eine Leiterplatte mittels metallischer Kontakte (9) gemäß den voranstehenden Ansprüchen, **dadurch gekennzeichnet, dass** die Klauen (17) des elektrischen Anschlusses des Wirkgliedes zur Achse der genannten Klauen des elektrischen Anschlusses lotrechte Rippungen (21) aufweisen.

8. Verfahren zum Anschluss eines elektrischen Wirkgliedes an eine Leiterplatte mittels metallischer Kontakte gemäß den voranstehenden Anschlüssen, **dadurch gekennzeichnet, dass** die metallischen Kontakte (9) ebene Kontaktflächen an der Leiterplatte (13) aufweisen.

9. Verfahren zum Anschluss eines elektrischen Wirkgliedes an eine Leiterplatte (13) mittels metallischer Kontakte (9) gemäß den voranstehenden Ansprüchen, **dadurch gekennzeichnet, dass** die metallischen Kontakte gewölbte Kontaktflächen (11) an der Leiterplatte aufweisen.

10. Verfahren zum Anschluss eines elektrischen Wirkgliedes an eine Leiterplatte (13) mittels metallischer Kontakte gemäß den voranstehenden Ansprüchen, **dadurch gekennzeichnet, dass** die Leiterplatte Bohrungen (14) aufweist, die geeignet sind, zum Wirkglied gehörende Elemente zur mechanischen Führung und Befestigung durchtreten zu lassen.

11. Verfahren zum Anschluss eines elektrischen Wirkgliedes an eine Leiterplatte mittels metallischer Kontakte (9) gemäß den voranstehenden Ansprüchen, **dadurch gekennzeichnet, dass** die metallischen Kontakte aus Stahl realisiert sind.

12. Verfahren zum Anschluss eines elektrischen Wirkgliedes an eine Leiterplatte mittels metallischer Kontakte (9) gemäß den voranstehenden Ansprüchen, **dadurch gekennzeichnet, dass** die metallischen Kontakte eine Kontaktzone (11) in Sternform mit mehreren Zweigen aufweist.
